# EUROPEAN PATENT APPLICATION

(11) **EP 4 823 250 A1**
(43) Date of publication of application: **14.10.2026**
(21) Application number: 24915171.3
(22) Date of filing: 26.12.2024
(51) Int. Cl.: H05K 1/14, H01M 10/42, H05K 1/18, H05K 1/02, B60L 58/10

(54) **BATTERY MANAGEMENT ASSEMBLY, BATTERY PACK, AND VEHICLE**

(30) Priority: 07.01.2024 CN 202410020565
(71) Applicant: Guangzhou Xiaopeng Motors Technology Co., Ltd., Guangzhou, Guangdong 510000 (CN)
(72) Inventor: LIU, Guangsheng, Guangzhou, Guangdong 510000 (CN); XU, Haiqing, Guangzhou, Guangdong 510000 (CN); WANG, Bao, Guangzhou, Guangdong 510000 (CN); ZHONG, Liang, Guangzhou, Guangdong 510000 (CN)
(74) Representative: Ran, Handong
(86) International application number: PCT/CN2024/142736
(87) International publication number: WO 2025/145956

(57) **Abstract**

The present application relates to a battery management assembly, a battery pack, and a vehicle. The battery management assembly comprises a plurality of second circuit modules and a plurality of first circuit modules. The battery management assembly comprises: a first substrate, wherein the first substrate is provided with a plurality of first mounting positions for mounting the first circuit modules, at least two of the plurality of first mounting positions are connected to each other, and the plurality of first circuit modules are mounted on the plurality of first mounting positions; and a second substrate, wherein the second substrate is provided with a plurality of second mounting positions for mounting the second circuit modules, the plurality of second circuit modules are mounted on the plurality of second mounting positions, and the first substrate and the second substrate are electrically connected. By means of the technical solution of the present application, the electrical connection reliability is greatly improved, automatic production can be implemented, and production costs are greatly reduced.

## Description

The present application claims priority to Chinese Patent Application No. 202410020565X, entitled "Battery Management Assembly, Battery Pack, and Vehicle", and filed with China National Intellectual Property Administration on January 7, 2024, which is incorporated herein by reference in its entirety.

### TECHNICAL FIELD

The present application relates to the technical field of power batteries, and in particular to a battery management assembly, a battery pack, and a vehicle.

### BACKGROUND

Owing to the advantages of high energy density, rechargeability, safety, and environmental friendliness, power batteries are widely used in fields such as new energy vehicles, consumer electronics, and energy storage systems. As battery technology advances, design parameters for power batteries are continuously improving, particularly in the technological improvement of battery pack management assemblies.

A battery disconnect unit (BDU) is an assembly integrated within a battery pack. At present, BDUs are produced mainly on manual or semi-automatic production lines. In a BDU, electrical components of high-voltage circuits are connected by bolts, and low-voltage control circuits and high-voltage sampling circuits are connected via wire harnesses and connectors. This makes the process for assembling and connecting these components complicated and difficult to implement with full automation. Moreover, since these electrical components are connected by bolts, wire harnesses or connectors, materials including the electrical components, molded housings, copper busbars, wire harnesses, connectors and fasteners result in a complex bill of materials, which is not conducive to material classification and management. This not only imposes high requirements on material control, but also brings significant potential safety hazards to the reliability of electrical connections.

### SUMMARY OF THE INVENTION

A primary objective of the present application is to provide a battery management assembly, aiming to solve the technical problems of complicated assembly and connection processes, inability to achieve full automation, as well as significant potential safety hazards to the reliability of electrical connections caused when electrical components are connected via bolts, wire harnesses or connectors.

To achieve the above objective, the present application provides a battery management assembly including a plurality of second circuit modules, a plurality of first circuit modules, a first substrate, and a second substrate.

The first substrate is provided with a plurality of first mounting positions configured to mount the first circuit modules. At least two of the plurality of first mounting positions are connected to each other, and the plurality of first circuit modules are mounted at the plurality of first mounting positions.

The second substrate is provided with a plurality of second mounting positions configured to mount the second circuit modules, and the plurality of second circuit modules are mounted on the plurality of second mounting positions.

The first substrate and the second substrate are electrically connected.

In some embodiments, at least two of the plurality of second mounting positions are connected to each other.

In some embodiments, the second substrate is a conductive busbar.

In some embodiments, the first circuit modules include at least one of a power module, a relay control module, a circuit breaker control module, a communication module, a battery data sampling module, a shunt sampling module, and a monitoring module.

In some embodiments, the second circuit modules include at least one of a shunt, a main negative relay, a fast-charging negative relay, a capacitor switch relay, a capacitor, a boost relay, a fast-charging positive relay, a main positive relay, a pre-charging circuit, and a circuit breaker.

In some embodiments, the second substrate is provided with first interfaces correspondingly electrically connected to the second circuit modules.

In some embodiments, the first substrate and the second substrate are arranged substantially in parallel to each other; or the first substrate and the second substrate are arranged substantially perpendicular to each other.

In some embodiments, the first substrate includes a plurality of sub-first substrates, and any one of the sub-first substrates is electrically connected to at least one of the remaining sub-first substrates.

In some embodiments, the sub-first substrate and the second substrate are arranged with their surfaces facing each other, or the sub-first substrates are arranged on one side of the second substrate, and the sub-first substrate and the second substrate are arranged in an L-shape or a T-shape.

In some embodiments, one or more of the plurality of sub-first substrates are provided with first substrate interfaces, and the first substrate interfaces include a sampling interface, a communication interface, or a battery pack interaction interface.

In some embodiments, the battery management module further includes a third substrate. The first substrate is electrically connected to at least one of the second circuit modules on the second substrate via the third substrate.

In some embodiments, the third substrate is electrically connected to at least one of the following: a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal, of respective ones of the second circuit module.

The third substrate is electrically connected to at least one of the following: a positive control terminal of a main negative relay, a negative control terminal of the main negative relay, a positive control terminal of a fast-charging negative relay, a negative control terminal of the fast-charging negative relay, a positive control terminal of a capacitor switch relay, a negative control terminal of the capacitor switch relay, a positive control terminal of a boost relay, a negative control terminal of the boost relay, a positive control terminal of a fast-charging positive relay, a negative control terminal of the fast-charging positive relay, a positive control terminal of a main positive relay, a negative control terminal of the main positive relay, a positive control terminal of a pre-charging relay, a negative control terminal of the pre-charging relay, a positive control terminal of a circuit breaker, and a negative control terminal of the circuit breaker, of the second circuit modules.

In some embodiments, the third substrate is soldered to the first substrate, and the second circuit modules are soldered to the third substrate.

In some embodiments, sampling traces and control traces on the third substrate are arranged spaced apart from each other.

In some embodiments, the third substrate is a flexible printed circuit (FPC).

In some embodiments, one of the plurality of second circuit modules is a shunt, and the shunt is electrically connected to at least one of the first circuit modules on the first substrate.

In some embodiments, the shunt is connected to the first substrate via a wire harness, an FPC, or a socket connector.

In some embodiments, the first substrate is a printed circuit board assembly (PCBA).

In some embodiments, a first heat dissipation member is arranged on a side of the second substrate close to the second circuit module.

In some embodiments, the second substrate includes a first side and a second side facing away from each other; the first side of the second substrate is provided with at least one second circuit module; and the second side of the second substrate is provided with a second heat dissipation member.

In some embodiments, at least one of the second circuit modules is a pre-charging circuit; the battery management assembly further includes a second interface; the second interface is connected to the pre-charging circuit; and the second heat dissipation member is arranged on the second side of the second substrate at a position corresponding to the second interface.

In some embodiments, the battery management assembly further includes a third heat dissipation member having two opposite sides, and the battery management assembly includes a plurality of second substrates. The plurality of second substrates are attached to the two sides of the third heat dissipation member respectively.

In some embodiments, the plurality of second circuit modules are sequentially arranged on the second substrate along a first direction, and the first direction is a length direction of the second substrate.

In some embodiments, the plurality of second circuit modules include a shunt, a main negative relay, a fast-charging negative relay, a capacitor switch relay, a capacitor, a boost relay, a fast-charging positive relay, a main positive relay, a pre-charging circuit, and a circuit breaker which are sequentially arranged.

In some embodiments, the battery management assembly further includes third interfaces. The third interfaces include: a main negative interface, a discharge negative interface, a discharge positive interface, a fast-charging negative interface, a boost interface, a fast-charging positive interface, and a main positive interface which are arranged in sequence. The main negative interface is electrically connected to the shunt; the discharge negative interface is electrically connected to the main negative relay; the fast-charging negative interface is electrically connected to the fast-charging negative relay; the boost interface is electrically connected to the boost relay; the fast-charging positive interface is electrically connected to the fast-charging positive relay; and the main positive interface is electrically connected to the circuit breaker.

In some embodiments, the battery management assembly further includes at least one high-voltage interface. The high-voltage interface includes at least one of a battery pack external discharge interface, a battery pack external boost interface, a battery pack external charging interface, and a battery pack interaction interface.

In some embodiments, the plurality of second circuit modules form a plurality of columns of second circuit module groups along a width direction of the second substrate. Each of the second circuit module groups includes at least one second circuit module arranged in sequence along a length direction of the second substrate.

In some embodiments, the plurality of columns of the second circuit module groups include a first column of second circuit module group and a second column of second circuit module group.

The first column of second circuit module group includes at least one of a circuit breaker, a pre-charging circuit, a main positive relay, a fast-charging positive relay, and a boost relay.

The second column of second circuit module group includes at least one of a shunt, a main negative relay, a fast-charging negative relay, a capacitor switch relay, and a capacitor.

In some embodiments, the battery management assembly further includes fourth interfaces. The fourth interfaces include: at least one main interface, which includes at least one of a main negative interface and a main positive interface; and/or at least one positive interface, which includes at least one of a discharge positive interface, a fast-charging positive interface, and a boost interface; and/or at least one negative interface, which includes at least one of a discharge negative interface and a fast-charging negative interface.

In some embodiments, when the fourth interfaces include at least one positive interface and at least one negative interface, the at least one positive interface is arranged on the first side of the second substrate, and the at least one negative interface is arranged on the second side of the second substrate.

In some embodiments, the fourth interfaces include: at least one of a main negative interface and a main positive interface, with the main negative interface electrically connected to the shunt, and the main positive interface electrically connected to the circuit breaker; and/or at least one of a discharge positive interface, a fast-charging positive interface, and a boost interface, with the discharge positive interface electrically connected to the main positive relay, the fast-charging positive interface electrically connected to the fast-charging positive relay, and the boost interface electrically connected to the boost relay; and/or at least one of a discharge negative interface and a fast-charging negative interface, with the discharge negative interface electrically connected to the main negative relay, and the fast-charging negative interface electrically connected to the fast-charging negative relay.

In some embodiments, each second circuit module has a first side and a second side facing away from each other, as well as a third side connecting the first side and the second side. At least one contact is provided on the first side, the second side, or the third side of the second circuit module.

In some embodiments, the contacts include first contacts, second contacts, and third contacts.

The first contacts include at least one of the following: a controlled terminal of a main negative relay, a controlled terminal of a fast-charging negative relay, a controlled terminal of a capacitor switch relay, a controlled terminal of a boost relay, a controlled terminal of a fast-charging positive relay, a controlled terminal of a main positive relay, a controlled terminal of a pre-charging circuit, and a controlled terminal of a circuit breaker.

The second contacts include at least one of the following: a positive control terminal of a main negative relay, a negative control terminal of the main negative relay, a positive control terminal of a fast-charging negative relay, a negative control terminal of the fast-charging negative relay, a positive control terminal of a capacitor switch relay, a negative control terminal of the capacitor switch relay, a positive control terminal of a boost relay, a negative control terminal of the boost relay, a positive control terminal of a fast-charging positive relay, a negative control terminal of the fast-charging positive relay, a positive control terminal of a main positive relay, a negative control terminal of the main positive relay, a positive control terminal of a pre-charging circuit, a negative control terminal of the pre-charging circuit, a positive control terminal of a circuit breaker, and a negative control terminal of the circuit breaker; and

The third contacts include at least one of the following: a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal.

To achieve the above objective, the present application further proposes a battery pack including the above battery management assembly.

In some embodiments, a plurality of control boards are provided in the battery pack, and the plurality of control boards are electrically connected to the battery management assembly.

To achieve the above objective, the present application further proposes a vehicle including the above battery pack.

In the embodiments of the present application, a first substrate and a second substrate are electrically connected to each other; a plurality of first mounting positions configured to arrange a plurality of first circuit modules are arranged on the first substrate; and the first circuit modules are electrically connected to at least one of the first circuit modules via the first substrate. A plurality of second mounting positions configured to arrange a plurality of second circuit modules are arranged on the second substrate, and the second circuit modules are electrically connected to at least one of the second circuit modules via the second substrate. Through the above arrangement, various electrical components are electrically connected via the first substrate and the second substrate. The modules are free of wire harnesses, which greatly simplifies the assembly process. Moreover, both the first substrate and the second substrate are provided with mounting positions to mount various electrical components, which significantly improves the reliability of electrical connections, facilitates automated production, and greatly reduces production costs.

### BRIEF DESCRIPTION OF THE DRAWINGS

In order to more clearly illustrate the technical solutions in the embodiments of the present application or in related art, the accompanying drawings used in the description of the embodiments or the related art are briefly introduced below. Obviously, the drawings described below show merely some embodiments of the present application, and for those skilled in the art, other drawings may be obtained based on these drawings without any creative effort.
FIG. 1 is a schematic structural diagram of a battery management assembly provided in an embodiment of the present application.
FIG. 2 is a schematic structural diagram of a first substrate shown in FIG. 1.
FIG. 3 is a schematic structural diagram of a first circuit module shown in FIG. 1.
FIG. 4 is a schematic structural diagram of a second substrate shown in FIG. 1.
FIG. 5 is a schematic structural diagram of a battery management assembly provided in another embodiment of the present application.
FIG. 6 is a circuit schematic diagram of a second circuit module shown in FIG. 5.
FIG. 7 is a schematic structural diagram of a battery management assembly provided in still another embodiment of the present application.
FIG. 8 is a schematic structural diagram of a battery management assembly provided in yet another embodiment of the present application.
FIG. 9 is a schematic structural diagram showing a first substrate and a second substrate arranged perpendicularly to each other.
FIG. 10 is a schematic structural diagram of a battery management assembly provided in another embodiment of the present application.
FIG. 11 is a schematic structural diagram of a battery management assembly provided in another embodiment of the present application.
FIG. 12 is a schematic structural diagram of a battery management assembly provided in still another embodiment of the present application.
FIG. 13 is a schematic structural diagram of a pre-charging circuit of the battery management assembly of the present application.
FIG. 14 is a schematic structural diagram of a battery management assembly provided in another embodiment of the present application.
FIG. 15 is a schematic structural diagram of a battery management assembly provided in still another embodiment of the present application.
FIG. 16 is a schematic structural diagram of a battery management assembly provided in still another embodiment of the present application.
FIG. 17 is a schematic structural diagram of a battery management assembly provided in yet another embodiment of the present application.
FIG. 18 is a side schematic structural diagram of a square arrangement shown in FIG. 17.
FIG. 19 is a schematic structural diagram of a battery management assembly provided in another embodiment of the present application.
FIG. 20 is a schematic structural diagram of a battery management assembly provided in still another embodiment of the present application.
FIG. 21 is a schematic diagram of another structure of the second circuit module in FIG. 20.
FIG. 22 is a schematic diagram of still another structure of the second circuit module in FIG. 20.
FIG. 23 is a schematic diagram of a bottom structure of the second circuit module shown in FIG. 20.
FIG. 24 is a schematic structural diagram of a battery management assembly provided in another embodiment of the present application.
FIG. 25 is a side view of the battery management assembly shown in FIG. 24.
FIG. 26 is a schematic structural diagram of a battery management assembly provided in yet another embodiment of the present application.
FIG. 27 is a schematic structural diagram of a battery pack provided in an embodiment of the present application.

Reference numerals in the figures:

| Reference numeral | Name | Reference numeral | Name |
|---|---|---|---|
| 100 | First substrate | 152 | Battery data sampling module |
| 200 | Second substrate | 153 | Relay control module |
| 110 | First mounting position | 154 | Circuit breaker control module |
| 120 | Second circuit module | 155 | Communication module |
| 121 | First high-voltage distribution module | 156 | Monitoring module |
| 1211 | Shunt | 157 | Shunt sampling module |
| 1212 | Pre-charging circuit | 210 | Second mounting position |
| 1213 | Main negative relay | 300 | First interface |
| 1214 | Main positive relay | 400 | Third substrate |
| 1215 | Circuit breaker | 410 | Clearance |
| 122 | Second high-voltage distribution module | 500 | Second heat dissipation member |
| 1221 | Fast-charging negative relay | 600 | First heat dissipation member |
| 1222 | Capacitor switch relay | 700 | Third interface |
| 1223 | Capacitor | 710 | Main negative interface |
| 1224 | Boost relay | 720 | Discharge negative interface |
| 1225 | Fast-charging positive relay | 730 | Discharge positive interface |
| 123 | Electric drive assembly module | 740 | Fast-charging negative interface |
| 124 | Contact | 750 | Boost interface |
| 130 | Connecting member | 760 | Fast-charging positive interface |
| 140 | Sub-first substrate | 770 | Main positive interface |
| 150 | First circuit module | 800 | Control board |
| 151 | Power module | 900 | Third heat dissipation member |

The realization of the objectives, functional features and advantages of the present application will be further described in conjunction with the embodiments and the accompanying drawings.

### DETAILED DESCRIPTION

The technical solutions in the embodiments of the present application will be clearly and completely described below in conjunction with the accompanying drawings in these embodiments. Obviously, the described embodiments are merely some but not all of the embodiments of the present application. On the basis of the embodiments of the present application, all other embodiments obtained by those skilled in the art without any creative effort shall fall within the protection scope of the present application.

It should be noted that all directional indications (such as up, down, left, right, front, back) in the embodiments of the present application are merely used to explain relative positional relationships and movement conditions among various components in a specific state (e.g., as shown in the drawings). If that specific state changes, the directional indications may also change accordingly.

In addition, descriptions referring to "first", "second" and the like in the present application are for descriptive purposes only and shall not be construed as indicating or implying relative importance or implying the number of technical features indicated. Therefore, a feature defined as "first" or "second" may explicitly or implicitly include at least one such feature. In addition, the technical solutions of the various embodiments may be combined with each other, provided that such combinations can be implemented by those skilled in the art. If the combined technical solutions are contradictory or cannot be implemented, such combinations shall be deemed non-existent and shall not fall within the protection scope claimed by the present application.

BDU, namely a battery disconnect unit, is an assembly integrated within a battery pack. At present, BDUs are produced mainly on manual or semi-automatic production lines. In a BDU, electrical components of high-voltage circuits are connected by bolts, and low-voltage control circuits and high-voltage sampling circuits are connected via wire harnesses and connectors.

However, during the conception and implementation of the present application, the inventors have found at least the following problems.

The assembly and connection of these components are complicated and therefore cannot be implemented through full automation. Moreover, since electrical components are connected by bolts, wire harnesses or connectors, materials including electrical components, injection-molded housings, copper busbars, wire harnesses, connectors and fasteners result in a complex bill of materials, which is not conducive to material classification and management. This not only imposes high requirements on material control, but also brings significant potential safety hazards to the reliability of electrical connections.

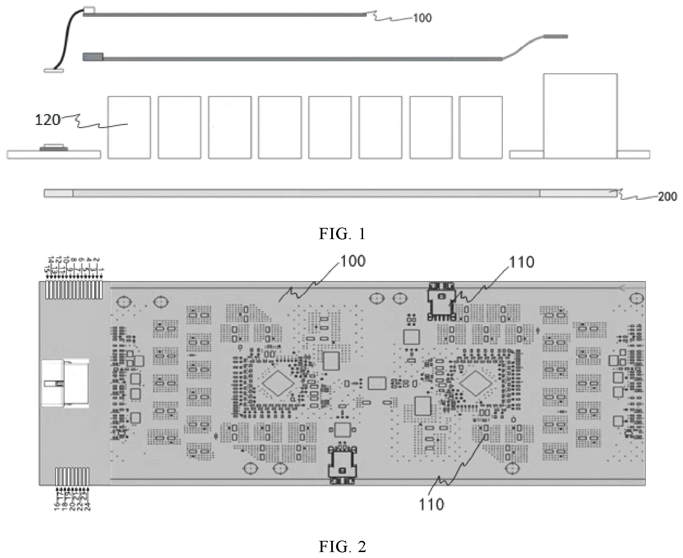

In order to solve the above problems, the present application proposes a battery management assembly. Referring to FIGs. 1 to 4, and 15, the battery management assembly proposed in the present application includes a plurality of second circuit modules 120, a plurality of first circuit modules 150, a first substrate 100, and a second substrate 200.

In this embodiment, the first substrate 100 is provided with a plurality of first mounting positions 110 configured to mount the first circuit modules 150. At least two of the plurality of first mounting positions 110 are connected to each other. The plurality of first circuit modules 150 are mounted on the plurality of first mounting positions 110.

The second substrate 200 is provided with a plurality of second mounting positions 210 configured to mount the second circuit modules 120. The plurality of second circuit modules 120 are mounted on the plurality of second mounting positions 210.

The first substrate 100 and the second substrate 200 are electrically connected.

In this embodiment, each of the second circuit modules 120 may be a circuit module for a high-voltage circuit, and each of the first circuit modules 150 may be a circuit module integrating a control circuit, a sampling circuit and a monitoring circuit. The first mounting positions 110 may each be a pad or a socket for mounting low-voltage electronic components, and the second mounting positions 210 may each be a pad or a socket for mounting high-voltage electronic components. The first substrate 100 may be a fiberglass board, a copper-clad laminate, a flexible printed circuit (FPC) or a single-sided aluminum board, and the second substrate 200 may be a fiberglass board, a copper-clad laminate or an FPC. This configuration facilitates the mounting of electronic components or electrical parts and enhances the reliability of carrying the electronic components or electrical parts.

In this embodiment, the first mounting positions 110 are arranged on the first substrate 100 in the form of pads or sockets for mounting the first circuit modules 150. That is, circuit modules with a control circuit, a sampling circuit, or a monitoring circuit are mounted on the first substrate 100, so that the first circuit modules 150 are electrically connected to other circuit modules via the first mounting positions 110. It will be appreciated that at least two of the first mounting positions 110 are connected to each other. For example, any two first mounting positions 110 may be electrically connected via circuit traces arranged on the first substrate 100. This enables electrical connection among a plurality of first circuit modules 150 to achieve the functions of circuit sampling, monitoring and control, and realize closed-loop control over the second circuit modules 120. The second mounting positions 210 are arranged on the second substrate 200 in the form of pads or sockets for mounting the second circuit modules 120. That is, circuit modules for high-voltage circuits are mounted on the second substrate 200. A second circuit module 120 is thus electrically connected to other second circuit modules 120 or the first circuit modules 150 via the second mounting positions 210. This ensures stable circuit operation, improves the stability of the battery management assembly during charging and discharging, and enhances the reliability of electrical connections.

It will be appreciated that in order to ensure more stable and reliable operation of the second circuit modules 120 after power-on, the second mounting positions 210 are provided with a larger overcurrent margin. At least two of the plurality of second mounting positions 210 are interconnected. That is, among the plurality of second mounting positions 210, at least two of them are connected to each other to enable electrical connection between the second circuit modules 120. However, some of the second mounting positions 210 are individually arranged for connecting to an external battery or motor. These individually arranged second mounting positions 210 are electrically connected with other second mounting positions 210 via the second circuit modules 120, rather than via traces on the second substrate 200. Through the above arrangement, electrical components are connected via a circuit board instead of wire harnesses. Reference can be made to FIG. 2 for connection modes, which will not be specifically limited herein.

In this embodiment, any two second mounting positions 210 are electrically connected to each other by circuit traces provided on the second substrate 200, such that a plurality of second circuit modules 120 are electrically connected to one another or a second circuit module 120 is electrically connected to a first circuit module 150.

In this embodiment, in order to achieve electrical connection between the first substrate 100 and the second substrate 200, that is, to achieve the effect of low voltage controlling high voltage and weak current controlling strong current, the first substrate 100 and the second substrate 200 may be electrically connected to each other via a connector socket or an FPC. Alternatively, the first substrate 100 and the second substrate 200 may be snap-fitted together vertically for electrical connection. Specifically, a connector socket may be arranged on the second substrate 200, and a gold finger may be arranged on the first substrate 100. By inserting the gold finger on the first substrate 100 into the connector socket on the second substrate 200, the first substrate 100 and the second substrate 200 can be stably electrically connected to each other, thereby ultimately enabling the first circuit module 150 to control the second circuit module 120.

In this embodiment, the first circuit modules 150 employ plug-in components or surface-mount components, and these electronic components are automatically inserted or mounted onto the first substrate 100 automated equipment. For example, the first substrate 100 may be provided with electronic components such as sampling components, control components, monitoring components, and power supply components. These electronic components are mounted on the first substrate 100 via the first mounting positions 110, thereby achieving functions such as control, sampling, or monitoring. The second substrate 200 is provided with electrical components such as relays, capacitors, circuit breakers, or shunts. These electrical components are fixedly mounted on the second substrate 200 via the second mounting positions 210, and connections between these electrical components are achieved without wire harnesses. This significantly improves the reliability of electrical connections. The second circuit modules adopt a plug-in connection method in which electrical components are automatically inserted onto the second substrate 200 by automated equipment. For example, the second substrate 200 may be provided with a fast-charging relay for fast-charging control, a main relay for discharge control, a boost relay for boosting the power of the DC charging socket, or a capacitor for energy storage, thereby achieving charging, discharging, or power boost functions. The electrical components are integrated on the second substrate 200 and are connected without wire harnesses, which provides stronger electrical connection stability.

In this embodiment, the second substrate 200 may be implemented using copper busbars or aluminum busbars, which can be of an integral or assembled structure. In some embodiments, the second substrate 200 of the present solution is an integrally injection-molded copper busbar, and it is not limited thereto in other embodiments.

In this embodiment, it is necessary to ensure that the battery management assembly can withstand both the continuous high current and the transient high current of the second circuit modules 120 during operation, thereby guaranteeing the stability and electrical connection reliability of the battery management assembly. Meanwhile, electromagnetic interference from the second circuit module 120 needs to be kept low to avoid interference with the first circuit module 150 or other circuit equipment, and a miniaturized and optimized layout is also desirable. To this end, an integrally injection-molded copper busbar may be adopted as the second substrate 200 to withstand the continuous and transient high currents of the second circuit module 120s. It will be appreciated that an integrally injection-molded copper busbar possesses excellent heat dissipation and current-carrying capabilities. By utilizing an integrally injection-molded copper busbar as the second substrate 200, not only is the current-carrying capacity enhanced, but the overheating of the second circuit module 120 is also prevented, thereby making the circuit operation more stable and reliable. Furthermore, securing the second circuit modules 120 by means of the integrally injection-molded copper busbar significantly simplifies the assembly process, greatly improves the reliability of electrical connections, enables automated production, and substantially reduces the production cost.

In this embodiment, the first substrate 100 is a printed circuit board assembly (PCBA ). Of course, in other embodiments, it is not limited hereto. For example, the first substrate 100 may be a flexible board or a rigid board. If it is a rigid board, it may be a fiberglass board, a copper-clad laminate, or a single-sided aluminum board. If it is a flexible board, it may be an FPC.

In this embodiment, the first substrate 100 may be a fiberglass board or a copper-clad laminate, or less preferably, an FPC, so that the first circuit modules 150 may be adapted to different mounting and usage environments, thereby achieving optimal control and optimal voltage and current withstand performance, and making operation of the circuit more stable and reliable.

In the technical solution of the present application, a first substrate 100 and a second substrate 200 are electrically connected to each other; a plurality of first mounting positions 110 configured to arrange a plurality of first circuit modules 150 are arranged on the first substrate 100; and one of the first circuit modules 150 is electrically connected to at least one of the remaining first circuit modules 150 via the first substrate 100. A plurality of second mounting positions 210 configured to arrange a plurality of second circuit modules 120 are arranged on the second substrate 200, and one of the second circuit modules 120 is electrically connected to at least one of the remaining second circuit modules 120 via the second substrate 200. In this way, various electrical components are electrically connected via the first substrate 100 and the second substrate 200, which eliminates the need for a large number of connecting wire harnesses for the electrical components as required in related art, and greatly simplifies the assembly process. Moreover, both the first substrate 100 and the second substrate 200 are provided with mounting positions to mount various electrical components. This significantly improves the reliability of electrical connections, enables automated production, and greatly reduces production costs.

In this embodiment, the first circuit modules 150 include at least one of a power module 151, a relay control module 153, a circuit breaker control module 154, a communication module 155, a battery data sampling module 152, a shunt sampling module 157, and a monitoring module 156.

In this embodiment, among the first circuit modules 150, the relay control module 153 and the circuit breaker control module 154 may be configured to realize control functions; the power module 151 may be configured to supply power to the electronic components in the first circuit modules 150; the communication module 155 may be configured to realize internal communication in the first circuit modules 150 or to execute communication with controllers external to the battery pack; the battery data sampling module 152 may be configured to sample the current, voltage, and temperature of the second circuit modules 120; the shunt sampling module 157 may be configured to sample the current of the second circuit modules 120; and the monitoring module 156 may be configured to monitor the insulation capability and heat of the second circuit modules 120. It will be appreciated that in order to better achieve the functions of sampling, monitoring, or controlling the second circuit modules 120, the above first circuit modules 150 may also include modules capable of implementing functions such as wireless communication or human-machine interaction (which are not specifically limited in this technical solution), to allow open-loop control or closed-loop control over the second circuit module 120s by the first circuit modules 150, thereby making the operation of the second circuit modules 120 more stable and reliable. It will be appreciated that the various modules described above may be provided simultaneously, or only any one or more of the modules may be provided, to achieve the required control, power supply, sampling, or monitoring functions. For example, it is possible to provide only a relay control module 153, to achieve open-loop control of each relay in the second circuit modules 120. For another example, only the circuit breaker control module 154 may be provided, to achieve control over the circuit breaker 1215. Alternatively, a shunt sampling module 157 and a circuit breaker control module 154 may be simultaneously provided, in which case the shunt sampling module 157 samples the total current on the second circuit modules 120 and feeds back the sampled signal to the relay control module 153, such that the relay control module 153 adjusts a control signal to be output to the second circuit modules 120. The above examples are merely simple illustrations. In realizing circuit functions, one or more of the above first circuit modules 150 may be provided as needed, and the present technical solution is not limited in this regard.

In this embodiment, the first circuit modules 150 may be a battery management system (BMS) control circuit. In the battery management assembly, a first circuit module 150 is configured to collect current and voltage signals of the second circuit modules 120, so as to perform corresponding control functions based on the current and voltage signals. A shunt on the second circuit modules 120 is configured to collect total current data of the second circuit modules 120 during their operation, and then feed back the data to the first circuit module 150 for processing. The first circuit module 150 then adjusts a control signal to be output to the second circuit modules 120 to stabilize voltage and current signals output from the second circuit modules 120 to the motor, or to stabilize voltage and current signals input from the DC charging socket to the second circuit modules 120. For example, a first circuit module 150 may be a power module 151 configured to supply power to the first circuit modules 150, a relay control module 153 configured to perform control functions on each relay on the second circuit module 120, a sampling module 158 configured to collect the operating status of various components in the high-voltage circuit, a circuit breaker control module 154 configured to control the circuit breaker 1215, a communication module 155 configured to establish communication connections with other circuit modules, or a charge confirmation module 156 configured to perform power management during battery charging. In addition, a first circuit module 150 may also be a wake-up module configured to wake up the first circuit modules 150 from a sleep state so that they perform control, sampling, or monitoring functions. With the arrangement of the wake-up module, the first circuit modules 150 are capable of automatically entering a sleep state after not having been used for a long time, and can be woken up by the wake-up module when needed, which helps reduce power consumption of the circuit board.

In this embodiment, at least two first circuit modules 150 are electrically connected to each other, such that the data collected by the sampling module 158 and the data monitored by the monitoring module 156 can be fed back to the relay control module 153 or the circuit breaker control module 154, and the relay control module 153 or the circuit breaker control module 154 may then send new control signals to the control terminals of each relay, thereby enabling the first circuit module 150 to sample and control the high-voltage circuit on the second circuit modules 120, or to monitor and manage the charging or discharging of the battery pack. This achieves optimal closed-loop control of the second circuit modules 120, and enhances their stability and reliability during operation.

It will be appreciated that the first substrate 100 in FIG. 2 is merely illustrative, and the arrangement of connecting members and various electronic components thereon is not specifically limited.

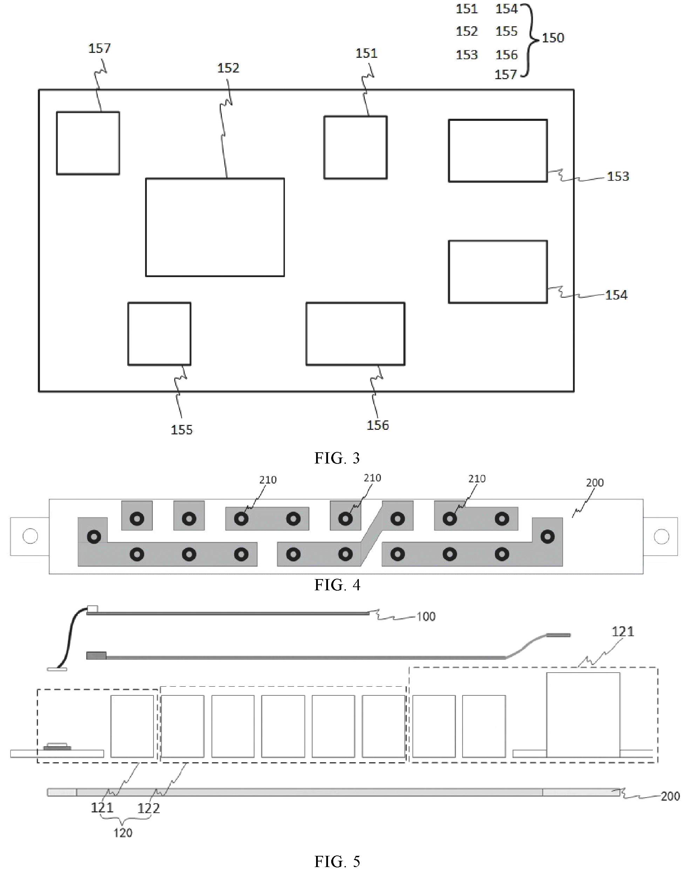

Referring to FIGs. 5, 6, 14 and 15, further, another embodiment of the present application provides a battery management assembly. Based on the embodiments shown in FIGs. 1 to 4, the second circuit modules include at least one of a shunt 1211, a main negative relay 1213, a fast-charging negative relay 1221, a capacitor switch relay 1222, a capacitor 1223, a boost relay 1224, a fast-charging positive relay 1225, a main positive relay 1214, a pre-charging circuit 1212, and a circuit breaker 1215.

In this embodiment, the second circuit modules 120 are configured to realize the charging and discharging functions of the battery as well as the control functions of the motor, thereby controlling the power input and output of the power battery pack and controlling the movement and stopping of the motor. For example, a first high-voltage distribution module 121 is formed by a circuit breaker 1215, a main positive relay 1214, a pre-charging circuit 1212, a main negative relay 1213, and a shunt 1211. The circuit breaker 1215 is connected to the main positive interface 770, and the shunt 1211 is connected to a main negative interface 710. The pre-charging circuit 1212 includes a pre-charging relay and a pre-charging resistor. The pre-charging resistor is configured to protect the pre-charging relay when the current flowing through the pre-charging relay is too high. The first high-voltage distribution module 121 is configured to control the power output or stop the power output of the power battery pack.

The circuit breaker 1215 is configured to promptly cut off the operation of the second circuit modules 120 when an excessive current occurs in the second circuit modules 120, thereby preventing the electrical components of the second circuit module 120 from burning out. The pre-charging circuit 1212 and the main positive relay 1214 are connected in parallel, primarily to prevent the main positive relay 1214 from being burned out due to excessive current flowing through the main positive relay 1214 during circuit startup. By arranging the pre-charging circuit 1212, at an initial stage of circuit startup, the first circuit module 150 controls the pre-charging relay to turn on and controls the main positive relay 1214 to turn off, thereby enabling the current to flow through the pre-charging circuit 1212. After the power supply operates stably, the first circuit module 150 controls the main positive relay 1214 to turn on and take over the work of the pre-charging circuit, thereby providing continuous and stable power to the motor, and thus enhancing circuit stability.

The second circuit modules include an electric drive assembly module 123 composed of a three-phase drive bridge circuit. The electric drive assembly module 123 is configured to invert the direct current from the power battery pack into three-phase alternating current and connect the three-phase alternating current to windings of the motor which are star-connected windings. The controlled terminals of the three-phase drive bridge circuit are connected to the output terminals of the first high-voltage distribution module 121. Through the switching operation of the three-phase drive bridge circuit, the motor is stably controlled, thereby ensuring a longer service life of the motor.

In this embodiment, a second high-voltage distribution module 122 is formed by the fast-charging positive relay 1225, the boost relay 1224, the capacitor 1223, the capacitor switch relay 1222 and the fast-charging negative relay 1221. The fast-charging positive relay 1225 is connected to the circuit breaker 1215 to connect the DC socket to the positive terminal of the power battery pack; the fast-charging negative relay 1221 is connected to the shunt 1211 to connect the DC socket to the negative terminal of the power battery pack; and the boost relay 1224 is configured to be connected to the neutral point of the three-phase motor windings, so as to supply a stable power supply to the motor windings, and ensure more stable and reliable operation of the motor. The second high-voltage distribution module 122 is configured to quickly charge the power battery pack with DC power via the DC socket, or to output power from the power battery pack to other vehicles or equipment.

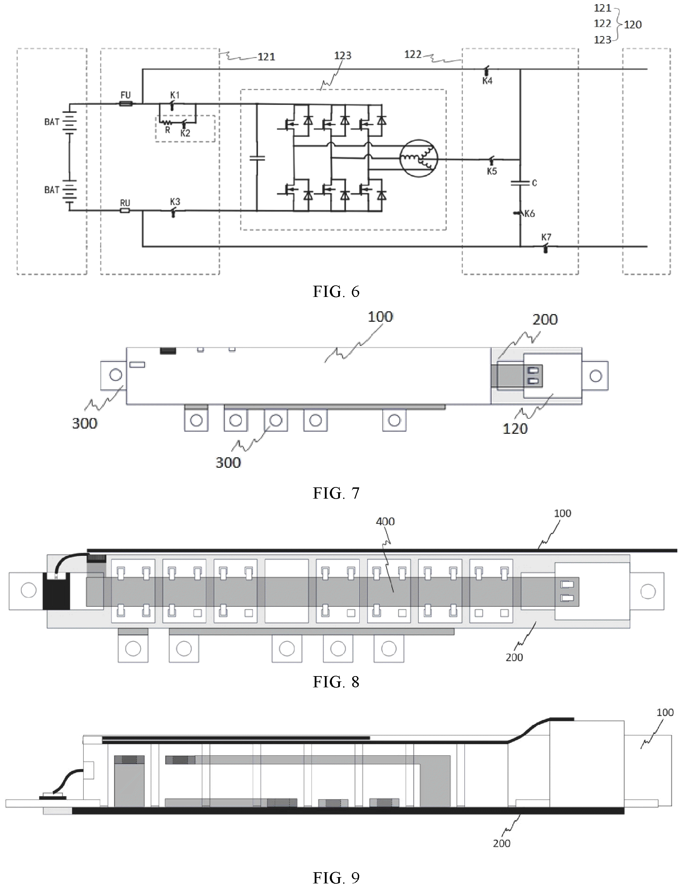

In this embodiment, referring to FIG. 6, FU is the circuit breaker 1215; K1 is the main positive relay 1214; K2 is the pre-charging relay of the pre-charging circuit 1212; K3 is the main negative relay 1213; RU is the shunt 1211; K4 is the fast-charging positive relay 1225; K5 is the boost relay 1224; C is the capacitor 1223; K6 is the capacitor switch relay 1222; and K7 is the fast-charging negative relay 1221.

It should be noted that it is possible to provide only one of the second circuit modules 120 described above. For example, only a single main positive relay 1214 may be provided to establish a conductive path between the motor and the battery, so as to achieve the battery discharging function. Alternatively, only a single fast-charging positive relay 1225 may be provided to achieve the function of conducting the path between the DC charging socket and the battery, thereby meeting the requirements for fast battery charging. In addition to providing a single second circuit module, it is also possible to provide the second circuit modules 120 in free combinations. For example, a circuit breaker 1215 and a main positive relay 1214 may be provided to protect the safety of circuit operation while achieving the function of conducting the path between the motor and the battery. The above examples are merely illustrative. In realizing the charging function or discharging function of the second circuit modules 120, one or more of the above second circuit modules 120 may be provided as needed, and the present technical solution is not limited in this regard.

Referring to FIG. 7, further, another embodiment of the present application provides a battery management assembly. Based on the embodiment shown in FIG. 1, the second substrate 200 is provided with first interfaces 300 electrically connected with respective ones of the second circuit modules 120.

In this embodiment, the first interfaces 300 serve as channels for the second circuit modules 120 on the second substrate 200 to connect externally to the motor or to the DC charging socket, for example, as an input channel through which the fast-charging relay inputs current to the battery pack, or an output channel through which the main relay outputs current to the motor. The first interfaces 300 include a main interface, a positive interface, and a negative interface, for delivering current to external circuits (such as the motor or a transformer) or for supplying the power from the battery pack or the DC charging socket to the second circuit modules 120. For example, the battery pack is connected via the main interface, and the DC charging socket is connected via the fast-charging relay. This enables the battery management assembly to interface with the power battery pack and the motor. In addition, since the interfaces are directly integrated on the second substrate 200 in this embodiment, the first interfaces 300 are electrically connected to the second circuit modules 120 via traces on the second substrate 200. Compared with the conventional methods in which wire harnesses are employed to connect and lead out the interfaces of the second circuit modules 120 individually, this approach offers higher electrical connection reliability. Moreover, since the interfaces are soldered onto the second substrate 200, the assembly process is simplified, and automated production can be better achieved.

Referring to FIGs. 1, 8, 9 and 19, further, still another embodiment of the present application provides a battery management assembly. Based on the embodiment shown in FIG. 1, the first substrate 100 and the second substrate 200 are arranged substantially parallel to each other; or, the first substrate 100 and the second substrate 200 are arranged substantially perpendicular to each other.

In this embodiment, for a better electrical connection between the first substrate 100 and the second substrate 200, the first substrate 100 and the second substrate 200 are arranged substantially parallel to each other. Either the first substrate 100 or the second substrate 200 is provided with a plug connector, and the other is provided with a socket connector. The plug connector and the socket connector may be quickly connected to each other to achieve electrical connection between the first substrate 100 and the second substrate 200. For example, the parallel arrangement may be a completely parallel arrangement, a substantially parallel arrangement, or an arrangement at a certain angle (e.g., there may be an angular difference of 10 degrees between the first substrate 100 and the second substrate 200), all of which are similar to the technical solution provided in the present application. Alternatively, the first substrate 100 and the second substrate 200 may be arranged substantially perpendicular to each other. For example, the substantially perpendicular arrangement may be a completely perpendicular arrangement or a connection with a certain inclination. For instance, the first substrate 100 may be directly inserted vertically into the second substrate 200, or inserted into the second substrate 200 in a nearly vertical manner. A slot or a socket connector, such as a double-data-rate three synchronous dynamic random-access memory (DDR3) type slot or a female header socket connector, may be provided on the second substrate 100, and a corresponding gold finger may be provided on the first substrate 100. The electrical connection between the first substrate 100 and the second substrate 200 is achieved by inserting the gold finger into the slot or the socket connector, thereby enabling stable transmission of high-voltage and low-voltage electrical signals.

In this embodiment, the first substrate 100 includes a plurality of sub-first substrates 140, and any one of the sub-first substrates 140 is electrically connected to at least one of the other sub-first substrates 140. The sub-first substrates may be arranged with surfaces thereof facing a surface of the second substrate, or the sub-first substrates may be arranged on one side of the second substrate, or the sub-first substrates and the second substrate are arranged in an L-shape or a T-shape.

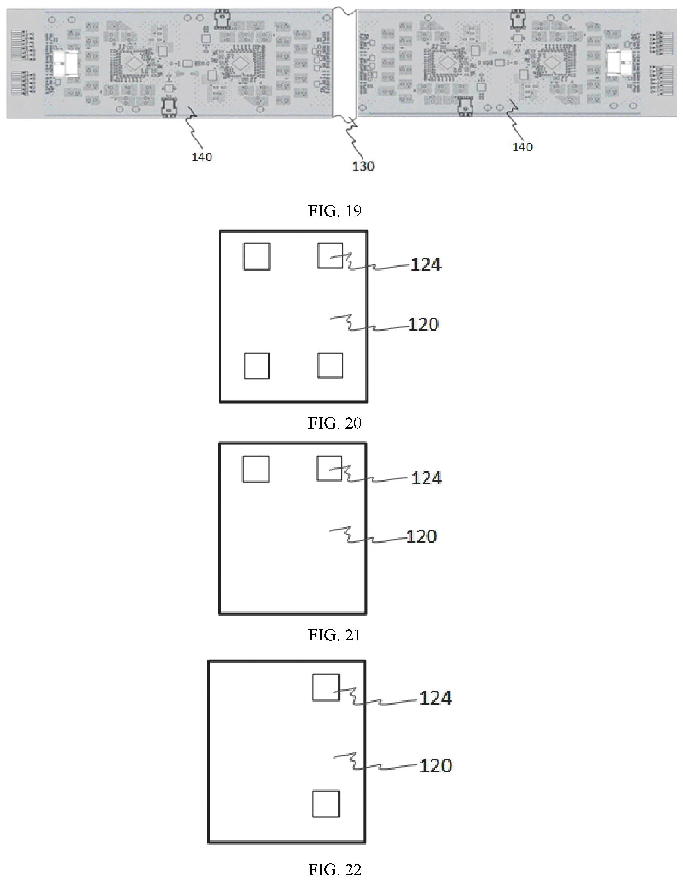

In this embodiment, the first substrate 100 has an elongated shape. To reduce the height of the battery management assembly, the width of the first substrate 100 needs to be reduced. With the circuit principles and components remaining unchanged, reducing the width inevitably increases the length. However, once the length of the circuit board exceeds a certain value, for example, when the aspect ratio reaches 10, the circuit board may bend, which significantly shortens the service life of the first substrate 100. To address this problem, in this embodiment, the first substrate 100 is cut and divided into a plurality of sub-first substrates 140 along the length direction, and adjacent sub-first substrates 140 are then connected via connecting members 130. The connecting members 130 may be, for example, FPC flexible boards. This can help avoid the problem of shortened service life caused by bending of an excessively long first substrate 100, thereby achieving higher stability of electrical connection of the first substrate 100. Furthermore, since the first substrate 100 is divided into a plurality of sub-first substrates 140, the sub-first substrates 140 may be connected to each other in various manners. FIG. 19 is merely illustrative and is not limiting. The sub-first substrates 140 may be electrically connected to each other either along the width side or along the long side. In actual use, the sub-first substrates 140 may be placed on the same side by flipping and folding, or may be distributed on different sides by changing the shape of the connecting members 130.

In this embodiment, one or more of the plurality of sub-first substrates 140 are provided with first substrate interfaces. The first substrate interfaces include a communication interface, a sampling interface, or a battery pack interaction interface.

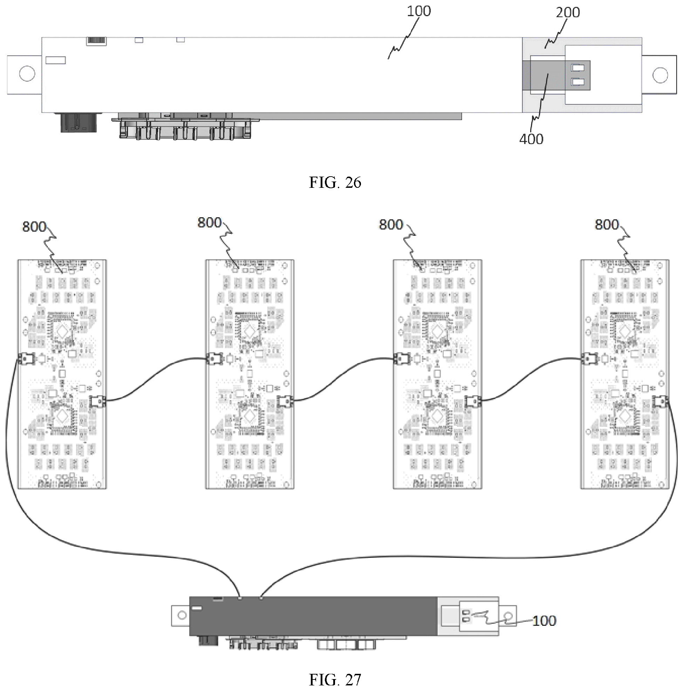

In this embodiment, the first substrate interfaces are interfaces for external connection of the battery management assembly to the battery pack, and are arranged on the first substrate. For example, as shown in FIG. 27, the communication interface is configured to enable communication connection between the first substrate 100 and each control board 800 via a daisy chain, wireless communication, or wired communication technology. For example, the battery pack interaction interface is configured to process charge confirmation signals, controller 12V power supply signals, wake-up signals, collision signals, communication signals, etc. For example, the sampling interface is configured to accurately collect voltage and current data of the battery pack to determine the operating status of the battery pack, thereby enhancing stability and reliability of the battery management assembly.

It will be appreciated that the third substrate 400 in FIG. 8 is shown in a see-through manner to avoid obstructing the structural illustration of the second circuit module 120. This does not specifically define that the third substrate 400 is transparent, nor does it indicate that the illustration is unclear. Furthermore, FIG. 19 is primarily intended to illustrate forms of the connecting members 130 between the sub-first substrates.

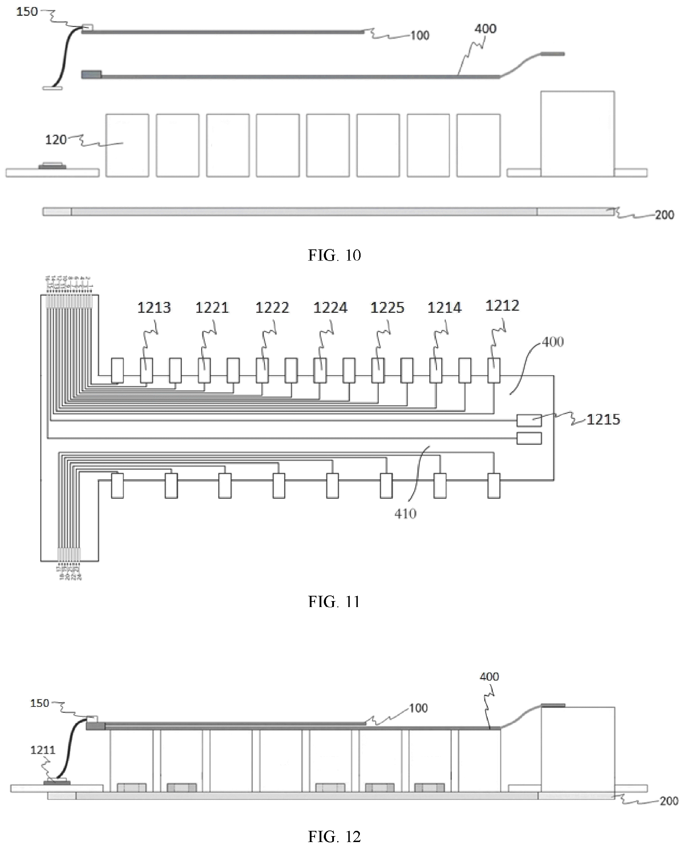

Referring to FIG. 10, further, another embodiment of the present application provides a battery management assembly. Based on the embodiment shown in FIGs. 1 to 9, the battery management assembly further includes a third substrate 400. The first substrate 100 is electrically connected to at least one second circuit module 120 on the second substrate 200 via the third substrate 400.

In this embodiment, the third substrate 400 may be a rigid board or a flexible board. If it is a rigid board, the third substrate 400 may be a copper-clad laminate or a fiberglass board. If it is a flexible board, the third substrate 400 may be an FPC.

In this embodiment, the third substrate 400 may be an FPC. The third substrate 400 is configured to connect the second circuit module 120 with the first substrate 100, thereby reducing wire harnesses used to connect the second circuit module 120 to the first substrate 100. Through the adapting of the third substrate 400, weak-current control over strong-current is achieved, and the stability and reliability of current transmission are significantly improved.

In this embodiment, the third substrate 400 is electrically connected to the first substrate 100 or the second circuit module 120 by plug-in connection, hot-press welding, laser welding, or snap-fit connection. For example, correspondingly matching socket connectors may be respectively provided on the first substrate 100 and the third substrate 400; or a gold finger pad may be provided on the third substrate 400, and a corresponding plug-in pad may be provided on the first substrate 100. Electrical connection between the gold finger pad and the plug-in pad can be achieved by plugging the gold finger pad into the plug-in pad. Alternatively, a gold finger pad is disposed on the third substrate 400, and a thermocompression pad is provided on the first substrate 100. Under the action of heat or ultrasonic waves, the gold finger pad on the third substrate 400 can be pressed and fixed onto the thermocompression pad on the first substrate 100 to achieve electrical connection between the third substrate 400 and the first substrate 100. In some embodiments, the first substrate 100 and the third substrate 400 are welded via hot-press welding. In some embodiments, the third substrate 400 and the first substrate 100 are hot-press welded together, so as to better output control signals from the first circuit modules 150 or collect operating status signals of the second circuit modules, and achieve stable and reliable high-voltage sampling or relay control.

In this embodiment, the third substrate 400 is electrically connected to the control terminals of the second circuit module 120. The contacts of the second circuit modules 120 are nickel sheets. To achieve better electrical connection between the nickel sheets and the third substrate 400, laser welding may be adopted for fixation. Alternatively, soldering using a soldering iron or other welding methods may be employed. In some embodiments, the third substrate 400 and the second circuit modules 120 are laser welded together. By fixed connecting the third substrate 400 to the second circuit modules 120 by means of laser welding, reliable electrical connection between the third substrate 400 and the second circuit module 120 is provided. Thus, control signals from the first circuit modules 150 can be better transmitted to respective control contacts of each second circuit module via the third substrate 400, or signals from respective sampling contacts can be better transmitted to the first circuit modules 150 via the third substrate 400. This enhances the stability and reliability of the control process, and significantly improves the transmission stability and reliability of both control signals and sampling signals.

Referring to FIGs. 11 and 12, further, still another embodiment of the present application provides a battery management assembly. Based on the embodiment shown in FIG. 10, the third substrate 400 is electrically connected to at least one of a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal of the second circuit modules 120. The third substrate 400 is electrically connected to at least one of a positive control terminal of the main negative relay 1213, a negative control terminal of the main negative relay 1213, a positive control terminal of the fast-charging negative relay 1221, a negative control terminal of the fast-charging negative relay 1221, a positive control terminal of the capacitor switch relay 1222, a negative control terminal of the capacitor switch relay 1222, a positive control terminal of the boost relay 1224, a negative control terminal of the boost relay 1224, a positive control terminal of the fast-charging positive relay 1225, a negative control terminal of the fast-charging positive relay 1225, a positive control terminal of the main positive relay 1214, a negative control terminal of the main positive relay 1214, a positive control terminal of the pre-charging relay, a negative control terminal of the pre-charging relay, a positive control terminal of the circuit breaker 1215, and a negative control terminal of the circuit breaker 1215 of the second circuit modules.

In this embodiment, the third substrate 400 is provided with sampling terminals and control terminals, which are connected to corresponding contacts to implement control or sampling functions. By the adapting of the third substrate 400, all sampling terminals and control terminals on the second circuit module 120 are electrically connected to the first substrate 100. For example, the first substrate 100 is provided with corresponding sampling modules and control modules to perform relevant sampling and control functions, thereby enabling the first circuit module 150 to implement closed-loop control over the second circuit module 120, and making the charging or discharging processes of the second circuit module 120 more stable and reliable.

In this embodiment, sampling traces and control traces on the third substrate 400 are spaced apart from each other.

In this embodiment, the third substrate 400 is connected to sampling terminals of the second circuit modules 120 to form sampling traces connected to the first substrate 100, and is connected to control terminals of the second circuit modules 120 to form control traces connected to the first substrate 100. The sampling traces are high-voltage traces configured to collect high-voltage signals from the second circuit modules 120, while the control traces are low-voltage traces configured to send control signals to control switching of the relays. The sampling traces are separated from the control traces to prevent high voltage from interfering with low-voltage signals. In this circuit, if the sampling traces and the control traces are not separated, the control signals may become unstable, leading to unstable battery operation and consequently posing safety risks. By spacing the two circuits apart, corresponding clearances 410 are formed. The spaced-apart arrangement may include, for example, partitioning ground layers, increasing trace spacing, and forming slots. For example, while ensuring sufficient clearance, the overall size of the third substrate 400 should be kept small. In this way, the high-voltage circuit and the low-voltage circuit are isolated from each other and operate independently, the low-voltage control circuit is protected from high-voltage fluctuations, an integrated and miniaturized overall circuit structure is achieved, and the stability of the first circuit modules 150 is improved.

In this embodiment, the connection traces of the second circuit modules 120 and the connection traces of the first circuit modules 150 are spaced apart, forming clearances 410. The arrangement of clearances 410 is a way to resist interference by increasing trace spacing, and can effectively prevent electromagnetic interference from the high-voltage sampling circuit from affecting the operation of the low-voltage control circuit. For example, based on voltage levels, a minimum trace spacing that ensures interference-free operation between the high-voltage and low-voltage circuits is determined and serves as a basis for trace layout design to ensure the separation of high-voltage and low-voltage signal routing, thereby protecting the low-voltage control circuit from high-voltage fluctuations and providing enhanced circuit stability.

Referring to FIG. 12, further, still another embodiment of the present application provides a battery management assembly. Based on the embodiment shown in FIG. 1, one of the plurality of second circuit modules 120 is a shunt 1211, and the shunt 1211 is electrically connected to at least one of the first circuit modules 150 on the first substrate 100. The shunt 1211 is connected to the first substrate 100 via a wire harness or an FPC. The shunt 1211 is connected to the first substrate 100 via a socket connector.

In this embodiment, the shunt 1211 is configured to sample the current of the high-voltage circuit and is electrically connected to at least one first circuit module 150 on the first substrate 100. That is, the shunt 1211, after sampling the high-voltage circuit, is electrically connected to one or more first circuit modules 150 on the first substrate 100 for signal transmission. During signal transmission, since the shunt 1211 performs signal conversion, the high-voltage signal does not flow directly through the first substrate 100, thereby avoiding the risk of high-voltage breakdown of the first substrate 100. This enables safe low-voltage operation, prevents the high-voltage signals on the second substrate 200 from affecting the operational stability of the first substrate 100, and thus provides better electrical performance.

In this embodiment, to facilitate the electrical connection between the shunt 1211 and the first substrate 100, a socket connector, a wire harness, or an FPC is provided, such that the shunt 1211 transmits signals to the first substrate 100. This enhances the stability and reliability of the signal transmission process.

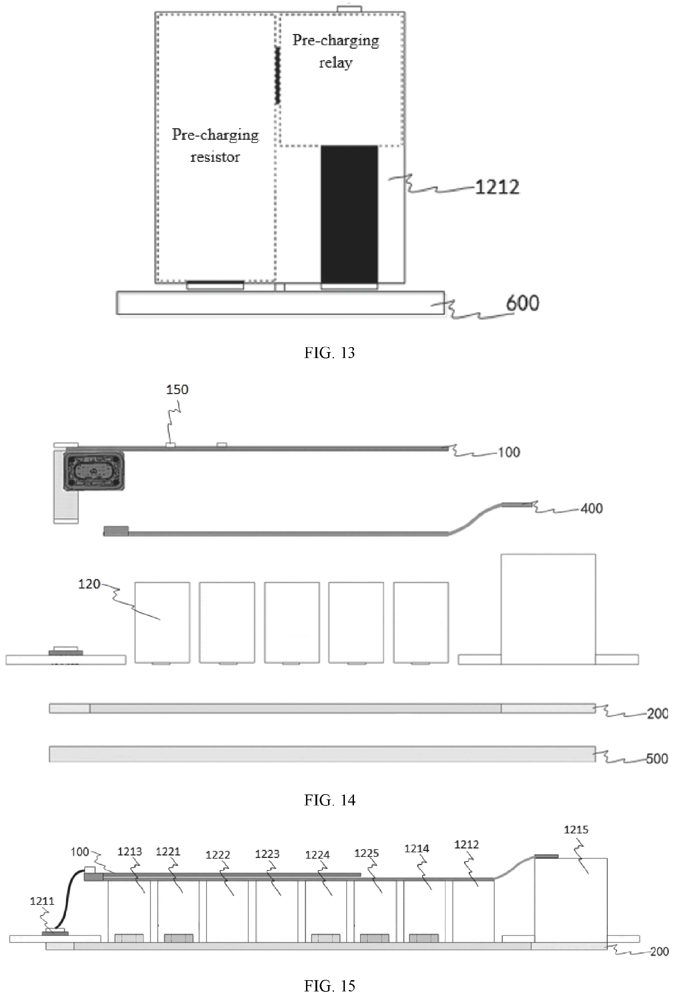

Referring to FIG. 13, further, another embodiment of the present application provides a battery management assembly. Based on the embodiment shown in FIG. 1, a first heat dissipation member 600 is arranged on a side of the second substrate 200 adjacent to the second circuit modules 120.

In this embodiment, the second circuit modules 120 are high-voltage circuits, which tend to generate significant heat during operation. To reduce the heat generated by the second circuit modules 120 and thereby extend the service life of the electronic components, a first heat dissipation member 600 may be provided near electronic components with high heat generation. That is, the first heat dissipation member 600 is arranged on the side of the second substrate 200 facing away from the first substrate 100. For example, the first heat dissipation member 600 is in contact with the second substrate 200 and has a size similar to that of the second circuit module 120, thereby enabling the first heat dissipation member 600 to effectively dissipate heat and efficiently dissipate the heat generated during the operation of the high-voltage circuit. The first heat dissipation member 600 may be a cooling copper busbar, which is not particularly limited in the present application.

Referring to FIGs. 3, 13 and 14, further, still another embodiment of the present application provides a battery management assembly. Based on the embodiment shown in FIG. 1, the second substrate 200 has a first side and a second side facing away from each other. The first side of the second substrate 200 is provided with at least one second circuit module 120, and the second side of the second substrate is provided with a second heat dissipation member 500.

In this embodiment, a heat dissipation metal plate may be employed as the second heat dissipation member 500 to provide heat dissipation for the entire second substrate 200. For example, the second heat dissipation member 500 may have a size equal to, slightly smaller than, or slightly greater than the size of the second circuit module 120. By arranging the second heat dissipation member 500 to be in close contact with the second substrate 200, heat from the second substrate 200 can be promptly conducted to the external environment, such that heat from the second circuit modules 120 is timely carried away via the second substrate 200, and efficient heat dissipation is achieved for components with high heat generation. The high heat dissipation efficiency helps prevent electronic components from burning out.

It will be appreciated that as shown in FIG. 14, with the top, bottom, left, and right directions in the figure as reference directions, the first side mentioned in this embodiment refers to the upper side of the second substrate 200. The second circuit modules 120 are arranged on the first side, and the third substrate 400 and the first substrate 100 are arranged above the second circuit module 120. The second side refers to the lower side of the second substrate 200, and the second heat dissipation member 500 is arranged at a position in contact with the second side, which is not limited in other embodiments.

In this embodiment, at least one of the second circuit modules 120 may be a pre-charging circuit 1212, and the battery management assembly further includes a second interface. The second interface is connected to the pre-charging circuit 1212. The second heat dissipation member 500 is arranged on the second side of the second substrate at a position corresponding to the second interface.

In this embodiment, the second circuit modules 120 include a pre-charging circuit 1212. The pre-charging circuit 1212 is configured to prevent an excessive starting current from burning out the main positive relay 1214 when the first circuit module 150 controls the startup of the electric drive assembly module. As shown in FIG. 6, in this embodiment, the pre-charging circuit 1212 may be connected in parallel across the main positive relay 1214. When the electric drive assembly module starts, the first circuit module 150 controls the main positive relay 1214 to turn off, and controls the pre-charging circuit 1212 to turn on, such that the starting current flows through the pre-charging circuit 1212. Once the circuit current is stabilized, the main positive relay 1214 is then closed.

Meanwhile, when the pre-charging circuit 1212 is turned on, a large starting current flows through the pre-charging resistor in the pre-charging circuit 1212, causing the pre-charging circuit 1212 to generate heat. In view of this, a second heat dissipation member 500 may be arranged on the side of the second substrate 200 that faces away from the pre-charging circuit 1212. The second heat dissipation member 500 is also connected to a second interface on the pre-charging circuit 1212, thereby allowing the pre-charging circuit 1212 to transfer and dissipate heat, and achieving temperature reduction management of components. The second heat dissipation member 500 dissipates the heat from the pre-charging resistor, thus enhancing stability of the circuit.

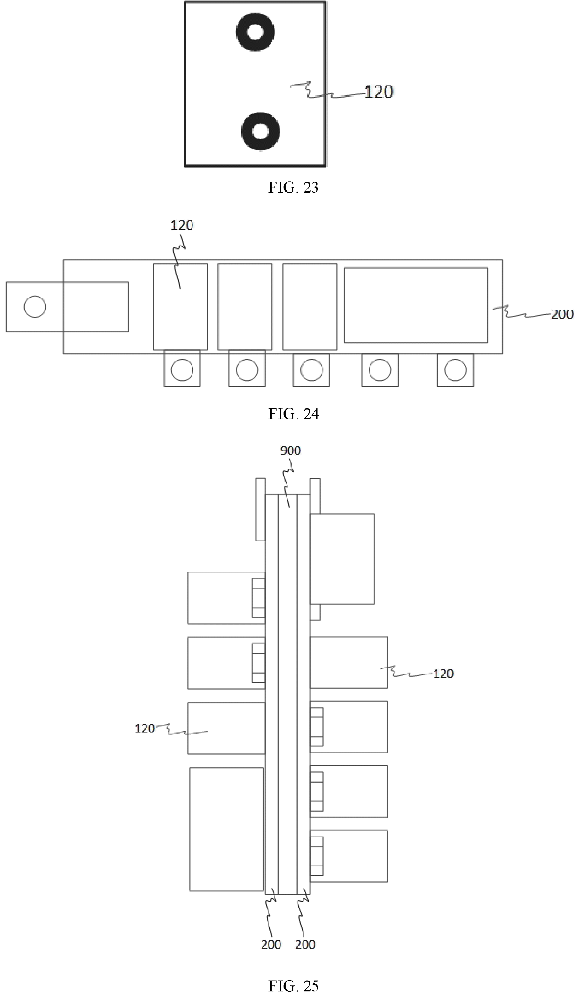

Referring to FIGs. 24 and 25, further, still another embodiment of the present application provides a battery management assembly. Based on the embodiment shown in FIG. 1, the battery management assembly further includes a third heat dissipation member 900. The third heat dissipation member 900 has two opposite sides. A plurality of second substrates 200 are provided, and the plurality of second substrates 200 are respectively arranged on and in contact with the two sides of the third heat dissipation member 900.

In this embodiment, in order to maximize the utilization of the third heat dissipation member 900, second substrates 200 are arranged on the two opposite sides of the third heat dissipation member 900, and are in tight contact with respective ones of the two sides of the third heat dissipation member 900. The second substrates 200 on the two sides are connected to each other via connectors. Since the third heat dissipation member 900 is relatively thin, the distance between the two second substrates 200 is short. A U-shaped pin header or a connector may be employed to electrically connect the second substrates 200 arranged on both sides of the third heat dissipation member 900, thereby providing better electrical connection between the second substrates 200 while meeting heat dissipation requirements and reducing space occupancy, and enhancing the operational stability of the second circuit module 120.

In this embodiment, the third heat dissipation member 900 may be a heat dissipation metal plate, for example, a heat dissipation copper busbar, which is similar to or the same as the first heat dissipation member 600. At least one second substrate 200 is attached to each of two planar surfaces of the third heat dissipation member 900, and each of the second substrates 200 is provided with at least one second circuit module 120. The area of the third heat dissipation member 900 is not smaller than, or slightly smaller than, or equal to the area of the largest second substrate 200. The second substrates 200 are tightly attached to the third heat dissipation member 900, so that heat can be effectively dissipated, thereby ensuring more stable and reliable operation of the second circuit modules 120.

Referring to FIG. 15, further, still another embodiment of the present application provides a battery management assembly. Based on the embodiment in FIG. 1, the plurality of second circuit modules 120 are sequentially arranged on the second substrate 200 along a first direction. The first direction is a length direction of the second substrate 200. The plurality of second circuit modules include a shunt 1211, a main negative relay 1213, a fast-charging negative relay 1221, a capacitor switch relay 1222, a capacitor 1223, a boost relay 1224, a fast-charging positive relay 1225, a main positive relay 1214, a pre-charging circuit 1212, and a circuit breaker 1215, which are sequentially arranged.

In this embodiment, on the second substrate 200, the length direction is defined as the first direction. The electronic components are arranged on the upper surface of the second substrate 200 in sequence with required optimal spacing therebetween. The electronic components are sequenced according to electrical connection relationships among the high-voltage components, so that a clear and well-defined trace layout is formed on the second substrate 200, with no overlapping traces. This allows the circuit to operate more stably and reliably. Moreover, such a well-defined layout enables faster and more efficient soldering and mounting by automated equipment. In addition, a clear layout allows a soldering robot to mount components based on machine positioning when soldering the second circuit modules 120. This simplifies the mounting, facilitates the routing, and enhances reliability.

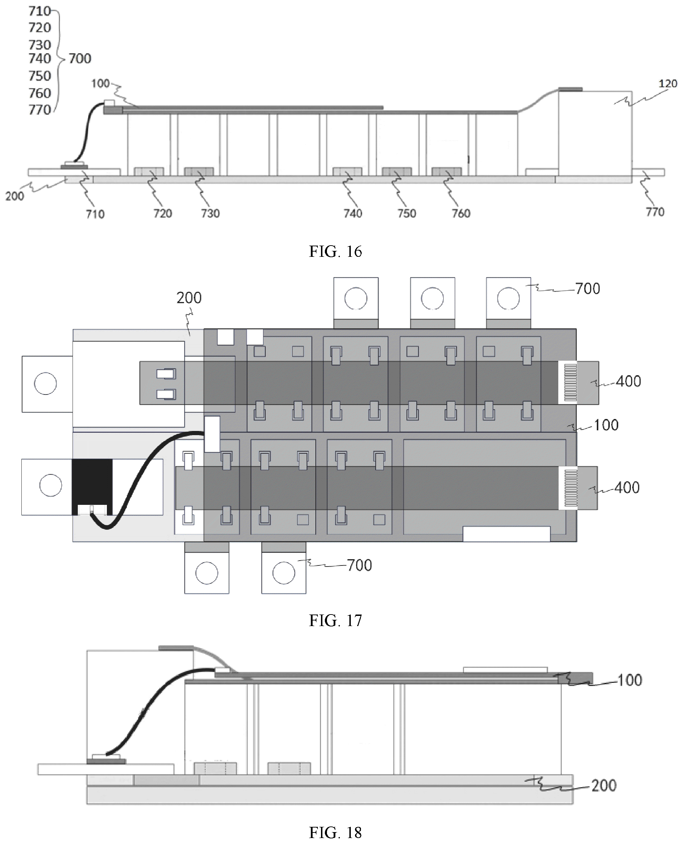

Referring to FIG. 16, further, another embodiment of the present application provides a battery management assembly. Based on the embodiment shown in FIG. 15, the battery management assembly further includes third interfaces 700, and the third interfaces 700 include one or more of a main negative interface 710, a discharge negative interface 720, a discharge positive interface 730, a fast-charging negative interface 740, a boost interface 750, a fast-charging positive interface 760, and a main positive interface 770, which are arranged in sequence. The main negative interface 710 is electrically connected to the shunt 1211; the discharge negative interface 720 is electrically connected to the main negative relay 1213; the fast-charging negative interface 740 is electrically connected to the fast-charging negative relay 1221; the boost interface 750 is electrically connected to the boost relay 1224; the fast-charging positive interface 760 is electrically connected to the fast-charging positive relay 1225; and the main positive interface 770 is electrically connected to the circuit breaker 1215.

In this embodiment, after arranging the components in sequence, it is necessary to lead out their output terminals via various interfaces to achieve control over the motor or a charging device, thereby realizing the charging and discharging of the power battery. The third interfaces 700 include one or more of a main negative interface 710, a discharge negative interface 720, a discharge positive interface 730, a fast-charging negative interface 740, a boost interface 750, a fast-charging positive interface 760, and a main positive interface, which are arranged in sequence. The above interfaces, for example, may be provided singly or in a combination, and it is not necessary to provide all of the above interfaces in every configuration. Relevant interfaces may be adjusted according to actual product requirements. In general, these interfaces mainly include three major types: main interfaces, positive interfaces, and negative interfaces. These three types of interfaces do not necessarily all appear simultaneously. For instance, for the discharge positive interface and the discharge negative interface, it is possible to provide only the discharge negative interface, and at least one positive interface and/or at least one negative interface are arranged in a straight line; the main interfaces are respectively arranged at two ends of the second substrate 200. That is, in the width direction of the second substrate 200, the positive interfaces and the negative interfaces are arranged on one side of the second circuit modules 120, i.e., on any side along the length direction of the second substrate 200; and all the positive interfaces and negative interfaces are arranged on the same side and are electrically connected to the second circuit modules 120. This achieves the leading out of the main interfaces, the positive interfaces, and the negative interfaces mentioned above, thereby realizing current input into battery or current output to the motor, enhancing the stability of current input to or current output from the second circuit modules 120, and thus effectively avoiding the problem of poor electrical connection stability in related technologies where the main interfaces, the positive interfaces, or the negative interfaces are led out directly via wire harnesses from the second circuit modules 120.

Referring to FIGs. 17 and 18, further, still another embodiment of the present application provides a battery management assembly. Based on the embodiment shown in FIG. 1, the plurality of second circuit modules 120 form a plurality of columns of second circuit module groups along a width direction of the second substrate 200; and each of the second circuit module groups includes at least one second circuit module 120 arranged in sequence along a length direction of the second substrate 200.

The plurality of columns of second circuit module groups include a first column of second circuit module group and a second column of second circuit module group. The first column of second circuit module group includes one or more of a circuit breaker 1215, a pre-charging circuit 1212, a main positive relay 1214, a fast-charging positive relay 1225, and a boost relay 1224; and the second column of second circuit module group includes one or more of a shunt 1211, a main negative relay 1213, a fast-charging negative relay 1221, a capacitor switch relay 1222, and a capacitor 1223.

In this embodiment, the elongated battery management assembly is cut and divided into a plurality of second circuit module groups along the long side of the second substrate 200. The second circuit module groups are then connected together at long sides thereof to obtain prolonged wide sides, such that the elongated second substrate 200 is converted into a square-shaped second substrate 200. For example, the second circuit modules may be divided into two second circuit module groups, and the two second circuit module groups may be arranged side by side along a width direction to form a square-shaped battery management assembly. This reduces the length and occupied space.

In this embodiment, after the relays, shunts, circuit breakers, and other electrical components are arranged in sequence, it is necessary to provide corresponding interfaces for these electrical components to lead out output terminals of the electrical components, thereby achieving control over the motor or the charging device and realizing charging and discharging of the power battery. Prior to this, the electrical components need to be arranged with required optimal spacing therebetween, and sequenced according to the electrical connection relationships among the high-voltage components, to obtain a clear and well-defined trace layout on the second substrate 200, with no overlapping traces. This results in less interference during the operation of the second circuit modules 120, and allows the circuit to operate more stably and reliably. Moreover, a well-defined layout enables faster and more efficient soldering and mounting by automated equipment, allows the soldering robot to mount components based on machine positioning when soldering the second circuit modules 120. This simplifies the mounting, facilitates the routing, and enhances reliability.

In this embodiment, the battery management assembly further includes fourth interfaces. The fourth interfaces include: at least one main interface, the at least one main interface including at least one of a main negative interface and a main positive interface; and/or at least one positive interface, the at least one positive interface including at least one of a discharge positive interface, a fast-charging positive interface, and a boost interface; and/or at least one negative interface, the at least one negative interface including at least one of a discharge negative interface and a fast-charging negative interface.

When at least one positive interface and at least one negative interface are included, the at least one positive interface is arranged on the first side of the second substrate, and the at least one negative interface is arranged on the second side of the second substrate.

The fourth interfaces include: at least one of a main negative interface 710 and a main positive interface 770 arranged along the width direction of the second substrate 200, with the main negative interface 710 electrically connected to the shunt 1211, and the main positive interface 770 electrically connected to the circuit breaker 1215; at least one of a discharge positive interface 730, a fast-charging positive interface 760, and a boost interface 750 which are arranged on a side of the second substrate 200 along the length direction, with the discharge positive interface 730 electrically connected to the main positive relay 1214, the fast-charging positive interface 760 electrically connected to the fast-charging positive relay 1225, and the boost interface 750 electrically connected to the boost relay 1224; and at least one of a discharge negative interface 720 and a fast-charging negative interface 740 which are arranged on the other side of the second substrate 200 along the length direction, with the discharge negative interface 720 electrically connected to the main negative relay 1213, and the fast-charging negative interface 740 electrically connected to the fast-charging negative relay 1221.

In this embodiment, the above interfaces may be provided singly or in plurality. It is not always necessary to provide all of the main interfaces, the positive interfaces, and the negative interfaces simultaneously. Instead, it is possible to provide only one type of interfaces, for example only the main interfaces, or two or all three types of interfaces. For example, after the components are arranged in sequence, it is necessary to lead out the output terminals via various interfaces to achieve control over the motor or the charging device, thereby realizing the charging and discharging of the power battery. In this embodiment, however, the second substrate 200 at this time is in a square shape and has a length that is greatly reduced compared to that of an elongated second substrate 200. Besides, the components are not distributed on a same side along the length direction. In this case, attempting to lead all the interfaces out to the same side would cause issues such as trace crossover and routing difficulties, as well as interference between the traces. To avoid these problems, the interfaces are arranged at different positions. For example, the fourth interfaces include three types of interfaces: main interfaces, positive interfaces, and negative interfaces. First, after the arrangement of the second circuit modules 120 as described above, it is determined that the main interfaces are located in the width direction of the second substrate 200, that the positive interfaces are located on one side of the second substrate 200 along the length direction, and that the negative interfaces are located on the other side of the second substrate 200 along the length direction. These interfaces are then electrically connected to respective second circuit modules 120 to achieve the leading out of the interface circuits. For example, the main interfaces include a main negative interface 710 and a main positive interface 770. The positive interfaces include a discharge positive interface 730, a fast-charging positive interface 760, and a boost interface 750; and the negative interfaces include a discharge negative interface 720 and a fast-charging negative interface 740. Such a layout design of the interfaces greatly improves the stability of circuit operation, and can, if properly designed, help avoid the issue of trace crossover, thereby eliminating the need for jumpers. This layout better meets the requirement of a modular design free of wire harnesses, greatly simplifies the assembly process, significantly improves the reliability of electrical connections, facilitates automated production, and thus substantially reduces manufacturing costs.

It will be appreciated that the third substrate 400 in FIG. 17 is shown in a see-through manner to avoid obstructing the structural illustration of the second circuit module 120. This does not specifically imply that the third substrate 400 is transparent, nor does it indicate that the illustration is unclear.

Referring to FIGs. 20 to 23, further, still another embodiment of the present application provides a battery management assembly. Based on the embodiment in FIG. 1, the second circuit modules are each provided with a first side and a second side facing away from each other, as well as a third side connecting the first side and the second side. At least one contact 124 is provided on the first side, the second side, or the third side of the second circuit module 120. The contacts include first contacts, and/or second contacts, and/or third contacts.

The first contacts include at least one of a controlled terminal of a main negative relay, a controlled terminal of a fast-charging negative relay, a controlled terminal of a capacitor switch relay, a controlled terminal of a boost relay, a controlled terminal of a fast-charging positive relay, a controlled terminal of a main positive relay, a controlled terminal of a pre-charging circuit, and a controlled terminal of a circuit breaker; the second contacts include one or more of a positive control terminal of a main negative relay, a negative control terminal of a main negative relay, a positive control terminal of a fast-charging negative relay, a negative control terminal of a fast-charging negative relay, a positive control terminal of a capacitor switch relay, a negative control terminal of a capacitor switch relay, a positive control terminal of a boost relay, a negative control terminal of a boost relay, a positive control terminal of a fast-charging positive relay, a negative control terminal of a fast-charging positive relay, a positive control terminal of a main positive relay, a negative control terminal of a main positive relay, a positive control terminal of a pre-charging relay, a negative control terminal of a pre-charging relay, a positive control terminal of a circuit breaker, and a negative control terminal of a circuit breaker; and the third contacts include one or more of a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal.

It will be appreciated that in this embodiment, at least one contact 124 is provided on the first side, the second side, or the third side of the second circuit module 120. That is, the entire second circuit module 120 may be provided with only one contact 124. When only one contact 124 is provided, it must be a first contact. For example, at least one first contact is provided, while a second contact and a third contact may or may not be provided. If a second contact and a third contact is provided, it is possible to provide only one second contact or only one third contact, or to provide a plurality of second/third contacts or a combination of both the second and third contacts. For instance, in the case that the component is a capacitor, it has only a first contact, without a second contact or a third contact. Relevant adjustments may be made according to different characteristics of the components and are not specifically limited in this solution.

In this embodiment, the contact 124 may be a controlled terminal of the second circuit module 120, a high-voltage sampling terminal, a low-voltage sampling terminal, or a control terminal of the second circuit module 120. The controlled terminal of the second circuit module 120 is a high-voltage controlled pin. In this embodiment, the high-voltage controlled pin is configured to be mounted on the second mounting position 210.

Further, to better implement open-loop and closed-loop control over the second circuit modules 120, a second contact and/or a third contact may be provided on the first side, the second side, or the third side of each second circuit module 120 (e.g., assuming that the first side is the side close to the second substrate 200, the second side is the side away from the second substrate 200, and the third side is the intermediate side surface connecting the first side and the second side), for sampling voltage and current during the operation of the second circuit module 120, or for controlling the switching of the second circuit module 120. Furthermore, when any two or all three of the first contact, the second contact, and the third contact are arranged simultaneously, they may be arranged on the same side (e.g., all on the first side) or on different sides (i.e., on the first side, the second side and the third side respectively), so as to facilitate the sampling and the controlling, as well as the electrical connection between the second circuit module 120 and the third substrate 400. In addition, this arrangement significantly enhances the flexibility of circuit layout, and allows designers to form a layout according to different design requirements of the battery management assembly and under safety regulations, thereby determining the positions of the contacts 124. For example, there is no specific limitation on the number of contacts 124 of the second circuit module 120. The quantity and positions of the contacts shown in the figures are merely for illustration, and shall not be construed as specific limitations thereto. Moreover, the shape of the contacts 124 is not limited to a square block, and it may also be circular, triangular, or any other shape that facilitates electrical connection with the third substrate 400. FIGs. 20 to 22 illustrate reference styles of the second contacts and the third contacts and are not specific limitations. FIG. 23 illustrates a reference style of the first contacts, and the style is not limited to what is shown in the figure.

Referring to FIG. 26, further, still another embodiment of the present application provides a battery management assembly. Based on the embodiment shown in FIG. 1, the battery management assembly further includes at least one high-voltage interface. The high-voltage interfaces include at least one of a battery pack external discharge interface, a battery pack external boost interface, a battery pack external charging interface, and a battery pack interaction interface.

In this embodiment, interfaces for discharging, boosting, charging, or control are provided on the side surface of the second circuit module 120, for quick connection and disconnection, thereby enabling rapid mounting of the battery management assembly. Its production can be automated, which is consistent with the concept of technical solutions of the present application. In addition, the control interface may be configured to transmit charge confirmation signals, controller 12V power supply signals, wake-up signals, collision signals, communication signals, etc., so as to achieve control functions. This layout better meets the requirement of a modular design free of wire harnesses, greatly simplifies the assembly process, significantly improves the reliability of electrical connections, enables automated production, and substantially reduces manufacturing costs.

The present application further provides a battery pack. The battery pack includes a battery management assembly. Reference can be made to the above embodiments for relevant structures of the battery management assembly. Since the battery pack of this embodiment adopts all the technical solutions of all the above embodiments, it has at least all the beneficial effects brought about by the technical solutions of the above embodiments, which will not be repeated herein.

Referring to FIG. 27, an embodiment of the present application provides a battery pack. A plurality of control boards 800 are arranged within the battery pack. The plurality of control boards 800 are electrically connected to the battery management assembly.

In this embodiment, the control board 800 controls its corresponding battery pack and is connected in series with adjacent control boards 800. The control boards 800 at two ends are electrically connected to the battery management assembly. The control boards 800 and the battery management assembly are connected in a wired manner or in a wireless manner (which may be Bluetooth or 4G). The battery management assembly is connected with a plurality of control boards 800, and each control board 800 independently collects or controls signals of a single battery pack, which enhances the stability and reliability. Moreover, overall control by the battery management assembly renders management more convenient and reliable.

In this embodiment, the plurality of control boards 800 and the battery management assembly communicate via the daisy chain technology.

Compared with controller area network (CAN) communication technology, the daisy chain technology adopted in this embodiment offers higher stability and reliability. When a battery fault occurs, the battery can be enabled to promptly stop operation, thereby preventing failure of the entire circuit caused by a single battery fault. Moreover, a plurality of devices can be connected using a limited number of signal transmission lines to share the same service, and issues such as bus contention and blocking are avoided.

The present application also proposes a vehicle. The vehicle includes the above battery pack. For the relevant structure of this battery pack, please refer to the above embodiments. Since the vehicle of this embodiment adopts all the technical solutions of all the above embodiments, it therefore has at least all the beneficial effects brought about by the technical solutions of the above embodiments, which will not be repeated herein.

The above is embodiments described in conjunction with specific contents, and it should not be considered that specific implementations of the present application are limited solely to these descriptions. Any variants that are similar or identical to the methods, structures and the like of the present application, or any technical deductions or substitutions made within the inventive concept of the present application, shall fall within the protection scope of the present application.

## Claims

1. A battery management assembly, comprising:
a plurality of first circuit modules and a plurality of second circuit modules;
a first substrate provided with a plurality of first mounting positions configured to mount the first circuit modules, wherein at least two of the plurality of first mounting positions are connected to each other, and the plurality of first circuit modules are mounted at the plurality of first mounting positions; and
a second substrate provided with a plurality of second mounting positions configured to mount the second circuit modules, wherein the plurality of second circuit modules are mounted at the plurality of second mounting positions,
wherein the first substrate and the second substrate are electrically connected to each other.

2. The battery management assembly according to claim 1, wherein at least two of the plurality of second mounting positions are connected to each other.

3. The battery management assembly according to claim 1, wherein the second substrate is a conductive busbar.

4. The battery management assembly according to claim 1, wherein the first circuit modules comprise at least one of a power module, a relay control module, a circuit breaker control module, a communication module, a battery data sampling module, a shunt sampling module, and a monitoring module.

5. The battery management assembly according to claim 1, wherein the second circuit modules comprise at least one of a shunt, a main negative relay, a fast-charging negative relay, a capacitor switch relay, a capacitor, a boost relay, a fast-charging positive relay, a main positive relay, a pre-charging circuit, and a circuit breaker.

6. The battery management assembly according to claim 5, wherein the second substrate is provided with first interfaces electrically connected to respective ones of the second circuit modules.

7. The battery management assembly according to claim 1, wherein:
the first substrate and the second substrate are arranged in parallel each other; or
the first substrate and the second substrate are arranged perpendicular to each other.

8. The battery management assembly according to claim 1, wherein the first substrate comprises a plurality of sub-first substrates, wherein any one of the sub-first substrates is electrically connected to at least one of the remaining sub-first substrates.

9. The battery management assembly according to claim 8, wherein:
the sub-first substrate and the second substrate are arranged with their surfaces facing each other; or
the sub-first substrates are arranged on one side of the second substrate, and the sub-first substrates and the second substrate are arranged in an L-shape or a T-shape.

10. The battery management assembly according to claim 8, wherein one or more of the plurality of sub-first substrates are provided with first substrate interfaces, wherein the first substrate interfaces comprise a communication interface, a sampling interface, or a battery pack interaction interface.

11. The battery management assembly according to any one of claims 1 to 10, further comprising a third substrate, wherein the first substrate is electrically connected to at least one of the second circuit modules on the second substrate via the third substrate.

12. The battery management assembly according to claim 11, wherein the third substrate is electrically connected to at least one of the following: a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal, of respective ones of the second circuit modules; and
the third substrate is electrically connected to at least one of the following: a positive control terminal of a main negative relay, a negative control terminal of the main negative relay, a positive control terminal of a fast-charging negative relay, a negative control terminal of the fast-charging negative relay, a positive control terminal of a capacitor switch relay, a negative control terminal of the capacitor switch relay, a positive control terminal of a boost relay, a negative control terminal of the boost relay, a positive control terminal of a fast-charging positive relay, a negative control terminal of the fast-charging positive relay, a positive control terminal of a main positive relay, a negative control terminal of the main positive relay, a positive control terminal of a pre-charging relay, a negative control terminal of the pre-charging relay, a positive control terminal of a circuit breaker, and a negative control terminal of the circuit breaker, of the second circuit modules.

13. The battery management assembly according to claim 11, wherein the third substrate is soldered to the first substrate, and the second circuit modules are soldered to the third substrate.

14. The battery management assembly according to claim 12, wherein sampling traces and control traces on the third substrate are spaced apart from each other.

15. The battery management assembly according to claim 11, wherein the third substrate is a flexible printed circuit.

16. The battery management assembly according to claim 1, wherein one of the plurality of second circuit modules is a shunt, and the shunt is electrically connected to at least one of the first circuit modules on the first substrate.

17. The battery management assembly according to claim 16, wherein the shunt is connected to the first substrate via a wire harness, a flexible printed circuit, or a socket connector.

18. The battery management assembly according to claim 1, wherein the first substrate is a printed circuit board assembly.

19. The battery management assembly according to claim 1, wherein a first heat dissipation member is arranged on a side of the second substrate close to the second circuit modules.

20. The battery management assembly according to claim 1, wherein the second substrate comprises a first side and a second side facing away from each other, wherein the first side of the second substrate is provided with at least one second circuit module, and the second side of the second substrate is provided with a second heat dissipation member.

21. The battery management assembly according to claim 20, wherein at least one of the second circuit modules is a pre-charging circuit, and the battery management assembly further comprises a second interface,
wherein the second interface is connected to the pre-charging circuit, and the second heat dissipation member is arranged on the second side of the second substrate at a position corresponding to the second interface.

22. The battery management assembly according to claim 1, wherein:
the battery management assembly further comprises a third heat dissipation member having two opposite sides; and
the battery management assembly comprises a plurality of second substrates,
wherein the plurality of second substrates are attached to the two sides of the third heat dissipation member respectively.

23. The battery management assembly according to claim 1, wherein the plurality of second circuit modules are sequentially arranged on the second substrate along a first direction, the first direction being a length direction of the second substrate.

24. The battery management assembly according to claim 23, wherein the plurality of second circuit modules comprise a shunt, a main negative relay, a fast-charging negative relay, a capacitor switch relay, a capacitor, a boost relay, a fast-charging positive relay, a main positive relay, a pre-charging circuit, and a circuit breaker which are sequentially arranged.

25. The battery management assembly according to claim 24, further comprising third interfaces, wherein the third interfaces comprise a main negative interface, a discharge negative interface, a discharge positive interface, a fast-charging negative interface, a boost interface, a fast-charging positive interface, and a main positive interface which are arranged in sequence, wherein:
the main negative interface is electrically connected to the shunt;
the discharge negative interface is electrically connected to the main negative relay;
the fast-charging negative interface is electrically connected to the fast-charging negative relay;
the boost interface is electrically connected to the boost relay;
the fast-charging positive interface is electrically connected to the fast-charging positive relay; and
the main positive interface is electrically connected to the circuit breaker.

26. The battery management assembly according to claim 1, further comprising at least one high-voltage interface, wherein the high-voltage interface comprises at least one of a battery pack external discharge interface, a battery pack external boost interface, a battery pack external charging interface, and a battery pack interaction interface.

27. The battery management assembly according to claim 1, wherein the plurality of second circuit modules form a plurality of columns of second circuit module groups along a width direction of the second substrate, wherein each of the second circuit module groups comprises at least one second circuit module arranged in sequence along a length direction of the second substrate.

28. The battery management assembly according to claim 27, wherein the plurality of columns of the second circuit module groups comprise a first column of second circuit module group and a second column of second circuit module group, wherein:
the first column of second circuit module group comprises at least one of a circuit breaker, a pre-charging circuit, a main positive relay, a fast-charging positive relay, and a boost relay; and
the second column of second circuit module group comprises at least one of a shunt, a main negative relay, a fast-charging negative relay, a capacitor switch relay, and a capacitor.

29. The battery management assembly according to claim 27, further comprising fourth interfaces, wherein the fourth interfaces comprise:
at least one main interface, wherein the at least one main interface comprises at least one of a main negative interface and a main positive interface; and/or
at least one positive interface, wherein the at least one positive interface comprises at least one of a discharge positive interface, a fast-charging positive interface, and a boost interface; and/or
at least one negative interface, wherein the at least one negative interface comprises at least one of a discharge negative interface and a fast-charging negative interface.

30. The battery management assembly according to claim 29, wherein when the fourth interfaces comprise at least one positive interface and at least one negative interface, the at least one positive interface is arranged on a first side of the second substrate, and the at least one negative interface is arranged on a second side of the second substrate.

31. The battery management assembly according to claim 30, wherein the fourth interfaces comprise:
at least one of a main negative interface and a main positive interface, wherein the main negative interface is electrically connected to the shunt, and the main positive interface is electrically connected to the circuit breaker; and/or
at least one of a discharge positive interface, a fast-charging positive interface, and a boost interface, wherein the discharge positive interface is electrically connected to the main positive relay, the fast-charging positive interface is electrically connected to the fast-charging positive relay, and the boost interface is electrically connected to the boost relay; and/or
at least one of a discharge negative interface and a fast-charging negative interface, wherein the discharge negative interface is electrically connected to the main negative relay, and the fast-charging negative interface is electrically connected to the fast-charging negative relay.

32. The battery management assembly according to claim 1, wherein each of the second circuit modules has a first side and a second side facing away from each other, as well as a third side connecting the first side and the second side, wherein at least one contact is provided on the first side, the second side, or the third side of the second circuit module.

33. The battery management assembly according to claim 32, wherein the contacts comprise first contacts, second contacts, and third contacts, wherein:
the first contacts comprise at least one of the following: a controlled terminal of a main negative relay, a controlled terminal of a fast-charging negative relay, a controlled terminal of a capacitor switch relay, a controlled terminal of a boost relay, a controlled terminal of a fast-charging positive relay, a controlled terminal of a main positive relay, a controlled terminal of a pre-charging circuit, and a controlled terminal of a circuit breaker;
the second contacts comprise at least one of the following: a positive control terminal of a main negative relay, a negative control terminal of the main negative relay, a positive control terminal of a fast-charging negative relay, a negative control terminal of the fast-charging negative relay, a positive control terminal of a capacitor switch relay, a negative control terminal of the capacitor switch relay, a positive control terminal of a boost relay, a negative control terminal of the boost relay, a positive control terminal of a fast-charging positive relay, a negative control terminal of the fast-charging positive relay, a positive control terminal of a main positive relay, a negative control terminal of the main positive relay, a positive control terminal of a pre-charging circuit, a negative control terminal of the pre-charging circuit, a positive control terminal of a circuit breaker, and a negative control terminal of the circuit breaker; and
the third contacts comprise at least one of the following: a battery main negative sampling terminal, a discharge negative sampling terminal, a fast-charging negative sampling terminal, a capacitor switch sampling terminal, a boost sampling terminal, a fast-charging positive sampling terminal, a discharge positive sampling terminal, and a battery main positive sampling terminal.

34. A battery pack, comprising the battery management assembly according to any one of claims 1 to 33.

35. The battery pack according to claim 34, wherein a plurality of control boards are provided in the battery pack, and the plurality of control boards are electrically connected to the battery management assembly.

36. A vehicle, comprising the battery pack according to any one of claims 34 to 35.
